# EUROPEAN PATENT APPLICATION

(11) **EP 1 641 047 A1**
(43) Date of publication of application: **29.03.2006**
(21) Application number: 05020797.6
(22) Date of filing: 23.09.2005
(51) Int. Cl.: H01L 31/05, C22C 5/08

(54) **Materials for interconnector of solar cell**

(30) Priority: 24.09.2004 JP 2004277959
(71) Applicant: TANAKA KIKINZOKU KOGYO KABUSHIKI KAISHA, Chuo-ku, Tokyo 103-8206 (JP)
(72) Inventor: Shima, Kunihiro, Chuo-ku, Tokyo 103-8206 (JP); Takada, Kazuyasu, Chuo-ku, Tokyo 103-8206 (JP)
(74) Representative: Klunker . Schmitt-Nilson . Hirsch

(57) **Abstract**

The present invention provides a material for an interconnector of a solar cell, comprising copper; calcium or strontium; and the balance silver. Desirable contents in the alloy are 0.08-0.8 by atomic percent with respect to copper, 0.015-0.15 by atomic percent with respect to calcium if added, and 0.005-0.2 by atomic percent with respect to strontium if added.

## Description

### Technical Field

The present invention relates to a material for an interconnector of a solar cell mounted in artificial satellites. Specifically, the present invention relates to a material for an interconnector, which does not soften due to heat cycle, and further is excellent in mechanical strength and has high electric conductivity.

### Background Art

As a material for an interconnector of a solar cell mounted in artificial satellites, alloy materials having silver as a main component have been conventionally known. One of the grounds silver alloys are used for the purpose is that silver has the highest electric conductivity in various metals, and addition of alloy elements to the main component of silver in an appropriate manner will make a suitable conductive member for an interconnector being used in outer space.

As the conventionally known materials for interconnectors of solar cells, Japanese Examined Patent Application Publication No. 7-83132 discloses a material composed of an Ag alloy containing 10 to 1000 ppm of Ca, Japanese Patent No. 2727729 discloses an alloy containing 10 to 750 ppm of one or more elements selected from a group consisting of: Be, rare earth elements such as La, Nb, Pr, and the like, and In; and the balance being Ag, and further Japanese Patent No. 2727730 discloses a material containing 10 to 1000 ppm of Ca, one or two or more elements selected from a group consisting of In, Be, and rare earth elements, and the balance being Ag.

These additive elements in the silver alloy in the materials for interconnectors address deterioration of material properties with age due to heat cycle in outer space. Specifically, outer space subjects to heat cycle between temperatures of - 200°C to +130°C, however pure silver will be recrystallized in the temperature range and soften in some processing histories because of its low recrystallization temperature. In this regard, addition of the above-described additive elements will increase the recrystallization temperature and inhibit property change due to heat cycle.

The conventional materials for interconnectors comprising of silver alloys have a certain degree of effects. However, the present inventors understand solar cells incorporating interconnectors employing the conventional silver alloy materials involve a risk of breakage during use.

The present invention has been made against a background of the above-described matters, and it is an object of the present invention to provide a material for an interconnector of a solar cell, which will inhibit softening of a material when subjected to heat cycle and will be less likely to cause breakage of the solar cell, which may happen in the course of use. In this case, the inventors sought a material, which cause as little deterioration in electric conductivity as possible.

### Disclosure of Invention

The present inventors studied some factors that damage an interconnector by the use thereof, in order to solve the above-described problems, and considered the factors lie in deficient strength of the materials per se. An interconnector is a member, which joins a plurality of solar cells for preparing a module, and during the process, the interconnector is joined with a substrate of the solar cells. The present inventors decided that heat cycle causes a thermal expansion difference between the interconnector and the substrate, and the interconnector cannot withstand stress cycle caused by the heat cycle and eventually ruptures, thereby damaging the solar cells. Therefore, the present inventors decided that, for obtaining more preferable materials for an interconnector, the strength of materials per se should be improved with the electric conductivity not being deteriorated, in addition to that merely hard-to-softened silver alloy should be made.

Consequently, the present inventors continued studies seeking for additive elements capable of improving strength without deteriorating electric conductivity, and discovered copper is effective in this respect. The present inventors further discovered calcium and strontium are suitable as additive elements in silver alloys in which copper has been adopted as an additive element, which elements can inhibit softening due to heat cycle, and reached the present invention.

Specifically, the present invention relates to a material for an interconnector for a solar cell, which comprises copper, calcium or strontium, and balance silver.

In the present invention, copper is used for improving the strength of silver as discussed above, and copper is an additive element, which can curb deterioration of electric conductivity of silver as much as possible. The content of copper is preferable if it is 0.08-0.8 by atomic %. The reason is that when it is lower than 0.08%, deficient strength of an alloy might rupture during use, and when it exceeds 0.8%, electric conductivity will deteriorate so prominently that an interconnector will not sufficiently function. An especially preferable additive rate is 0.15-0.35 by atomic %, because balance between strength and electric conductivity will be especially improved when calcium or strontium is added.

Third constituent elements calcium and strontium both act to inhibit softening of alloys over time caused by heat cycle of an alloy. Specifically, they are additive metals acting to raise a temperature at which softening starts, i.e. a softening-start temperature. In this case, when calcium is added, the content is preferable if it is 0.015-0.15 atomic %. The reason is that when the content is lower than 0.015%, any effect of raising a softening-start temperature is not tangible, thereby softening at a lower temperature will occur, and when the content exceeds 0.15%, electric conductivity will be remarkably deteriorated. A more preferable range of concentration of calcium is 0.03-0.06%.

In contrast, when strontium is added as a third constituent element, it is preferable if the content is 0.005-0.2% by atomic %. The reason is that when the content is lower than 0.005%, a softening-start temperature cannot be raised, thereby softening at a lower temperature will occur, and when the content exceeds 0.2%, strength will be remarkably deteriorated. A more preferable range of concentration of strontium is 0.01-0.1%. It should be noted that the reason that the range of concentration of strontium is higher is an additive element, which hardly deteriorates electric conductivity, however exhibits lower rising effect of softening-start temperature than calcium. Since calcium is an additive element, which has an effect of raising the softening-start temperature and improving strength, however acts stronger to deteriorate electric conductivity than strontium, it is preferable to keep calcium comparatively lower in additive concentration.

The silver alloy as a material for an interconnector according to the present invention can be produced through a normal induction melting method, and especially a solid solution alloy can be obtained through induction melting with the above-described composition range. In this case, it is preferable if the melting is carried out in vacuum to prevent the materials from being oxidized. After casting, materials for an interconnector can be formed foil or wiring through appropriate deformation processing methods.

As described above, the material for an interconnector according to the present invention has been improved in strength in addition that been inhibited from getting softened due to heat cycle, over the conventional materials consisting of silver alloys. The present invention can inhibit an interconnector of a solar cell from damages caused by softening due to heat cycle in outer space as well as by stress cycle, thereby insuring long-term reliability of a solar cell.

### Best Mode for Carrying Out the Invention

Hereinafter, preferred embodiments of the present invention will be described. In the present examples, silver-copper-calcium alloy and silver-copper-strontium alloy of various compositions were produced through a vacuum induction melting method. An induction-molten ingot was extruded to be 5.0mm in diameter, and consequently was wire-drawn to prepare a wire of 0.8mm in diameter.

The alloy wire thus produced was measured in terms of mechanical properties, electric conductivity, and softening-start temperature. Regarding mechanical properties, tensile strength via a tensile test, 0.2% proof stress, Young's modulus and elongation were measured, and hardness was measured via Vickers test. The softening-start temperature was obtained through applying heat treatments at various temperatures to worked materials, and measuring changes in hardness at heat treatment temperatures. Table 1 shows results of them. Table 1 also shows, as a comparative example, results of measurements similarly conducted on silver alloys to which calcium had been added, and on pure silver. Regarding the pure silver, values after annealing are shown because it gets soft in about 50 hours due to room-temperature aging after intensive working.

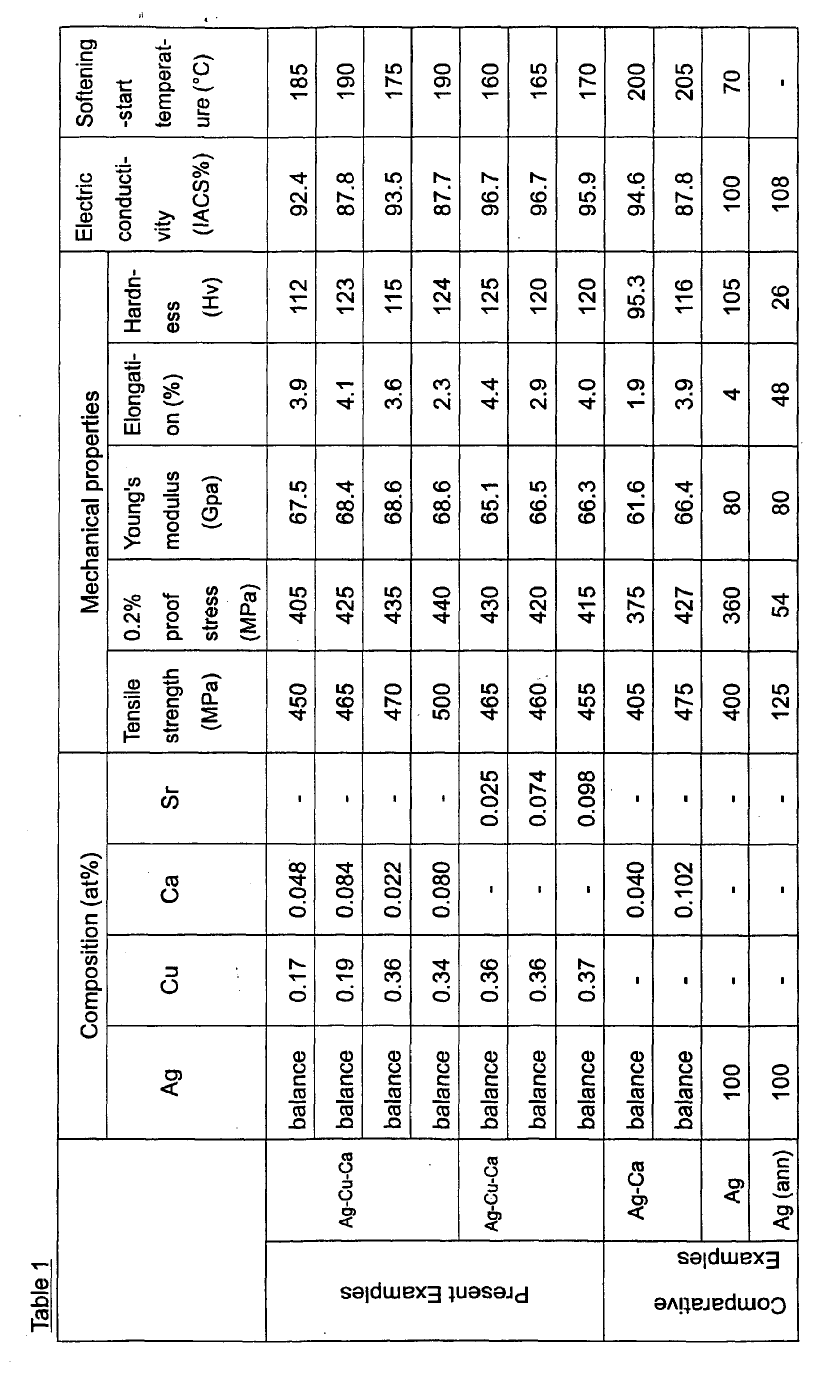

From Table 1, correlation between strength and electric conductivity is first studied. In consideration of application as a material for an interconnector, when target values for the both properties are assumed 450MPa or higher and 90%IACS, respectively, the silver-copper-calcium alloy and silver-copper-strontium alloy both met substantially the target values. However as far as the silver-copper-calcium alloy is concerned, the electric conductivity tends to deteriorate with an increase in concentration of calcium. In contrast, in the silver-calcium alloy in Comparative Examples, strength and a softening-start temperature increase with an addition of calcium, however electric conductivity will deteriorate accordingly. Therefore, inhibited concentration of calcium will provide strength having far below target values. The strength and electric conductivity of this alloy can be adjusted only through adjustment in concentration of calcium, and ultimately it is difficult to redress the balance.

With respect to a softening-start temperature, approximate 150°C can be set as a target value when, as described above, a fact that the maximum temperature of the heat cycle in outer space is on the order of 130°C is taken into consideration and some margins are coupled therewith. Thus, the silver-copper-calcium alloy and silver-copper-strontium alloy according to the present examples meet the target values sufficiently. The silver-calcium alloy meets the target values completely in terms of the softening-start temperature. However, the softening-start temperature is not necessarily required to be raised to 200°C or higher, and it is not preferable to evaluate the alloy in terms of the softening-start temperature only when the above-described issues of strength and electric conductivity are taken into consideration. Pure silver naturally has high electric conductivity, however the strength thereof, especially after annealing is low.

## Claims

1. A material for an interconnector of a solar cell, comprising a silver alloy,
**characterised in that** said material contains copper; calcium or strontium; and the balance being silver.

2. The material for an interconnector of a solar cell according to claim 1, wherein a copper content is 0.08-0.8% by atomic percent.

3. The material for an interconnector of a solar cell according to claim 1 or 2, wherein a calcium content is 0.015-0.15% by atomic percent.

4. The material for an interconnector of a solar cell according to claim 1 or 2, wherein a strontium content is 0.005-0.2% by atomic percent.
